(19) Europäisches Patentamt
European Patent Office
Office européen des brevets

(11) **EP 4 432 490 A1**

(12) **EUROPEAN PATENT APPLICATION**
published in accordance with Art. 153(4) EPC

(43) Date of publication:
**18.09.2024 Bulletin 2024/38**

(21) Application number: **23858648.1**

(22) Date of filing: **03.04.2023**

(51) International Patent Classification (IPC):
***H01S 5/183*** *(2006.01)*

(52) Cooperative Patent Classification (CPC):
**H01S 5/183**

(86) International application number:
**PCT/CN2023/085835**

(87) International publication number:
**WO 2024/045607 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.09.2022 US 202263403301 P
08.11.2022 CN 202211393706**

(71) Applicant: **Vertilite Co., Ltd.
Changzhou, Jiangsu 213000 (CN)**

(72) Inventors:
• **LIANG, Dong
  hangzhou, Jiangsu 213000 (CN)**
• **ZHANG, Cheng
  hangzhou, Jiangsu 213000 (CN)**

(74) Representative: **HGF
HGF Limited
1 City Walk
Leeds LS11 9DX (GB)**

(54) **GIANT CAVITY SURFACE EMITTING LASER**

(57)     A giant cavity surface-emitting laser includes a giant cavity (20), a lower Bragg reflector (10), and an upper Bragg reflector (30). The lower Bragg reflector (10) is located on a side of the giant cavity (20). The upper Bragg reflector (30) is located on a side of the giant cavity (20) facing away from the lower Bragg reflector (10). The giant cavity (20) includes a multi-junction active region (21) containing at least two active layers (210), and the giant cavity (20) includes at least one of: an anti-reflection light reservoir (22) located between the multi-junction active region (21) and the lower Bragg reflector (10) or an anti-reflection light reservoir (22) located between the multi-junction active region (21) and the upper Bragg reflector (30), where the anti-reflection light reservoir (22) is configured to increase an optical field intensity peak of the anti-reflection light reservoir (22) to a value higher than an optical field intensity peak of the multi-junction active region (21) and store optical field energy, and a current confinement layer (220) defining a light-emitting region is disposed within the multi-junction active region (21) or near the outer side of the multi-junction active region (21). The giant cavity surface-emitting laser greatly reduces a divergence angle and increases brightness and spectral brightness while maintaining single longitudinal mode lasing and avoiding the problems of complex fabrication, high cost, and low power density.

**FIG. 2**

**Description**

The present application claims priority to Chinese Patent Application No. 202211393706.X filed with the China National Intellectual Property Administration (CNIPA) on Nov. 8, 2022 and U.S. Application No. 63/403,301 titled "Giant cavity surface emitting laser" filled with the U.S. Patent Office on Sep. 2, 2022, the contents of which are incorporated herein by reference in their entireties.

TECHNICAL FIELD

The present application relates to the field of laser technologies, for example, a giant cavity surface-emitting laser.

BACKGROUND

As the mass production supply chain matures, due to compactness, fast response capabilities, and high energy conversion efficiency, the large-scale applications of vertical-cavity surface-emitting lasers (VCSELs) expand to autonomous driving, computing, virtualization and augmented reality, industrial rapid heating, aesthetic medicine, and other fields. A solid-state laser radar system equipped with VCSEL array light sources is developed and commercialized in autonomous vehicles.

High-resolution laser radar light sources have many performance indicators, and brightness and spectral brightness are particularly important for a laser radar (LiDAR) system. Currently, since the power density of the VCSEL is sufficient to satisfy the requirement of the LiDAR, there is an urgent need to reduce the beam divergence angle of the VCSEL to obtain higher brightness and spectral brightness. Since a lower beam divergence angle is usually accompanied by fewer higher-order modes and narrower spectral widths, the effect of the beam divergence angle on the spectral brightness is doubled. The divergence angle of the VCSEL is generally 20° to 30°, which is quite large for most medium- and long-range scanning LiDAR. Due to stronger lateral optical confinement, a multi-junction VCSEL with multiple oxide layers for current confinement has a larger divergence angle than a single-junction VCSEL, but reducing the number of the oxide layers in the multi-junction VCSEL results in the loss of power conversion efficiency (PCE). A method for reducing the beam divergence angle of the VCSEL while maintaining efficiency is to use an extended cavity to extend the cavity length, thereby reducing the contrast in effective refractive index between the inside and outside of the optical aperture of the VCSEL and suppressing higher-order lateral modes. However, after the cavity length is increased, the distance between laser longitudinal modes decreases, and multiple longitudinal modes appear in the emission spectrum of the VCSEL, that is, multiple spectral peaks appear. Among the multiple spectral peaks, in addition to the designed lasing wavelength, other undesired spectral peaks appear on one or two sides of the designed lasing wavelength and are commonly referred to as side modes. The appearance of the side modes causes some potential problems. For example, the receiving end of the LiDAR cannot recognize these side modes, resulting in lower efficiency and crosstalk. Other methods for reducing the divergence angle include using high-contrast gratings (HCGs), using slow-light optical amplifiers, integration of microlenses, or using different types of current confinement, such as ion implantation and buried tunnel junctions. However, these methods all have challenges, such as complex fabrication, high cost, low power density, and difficulty in achieving uniform light-emitting patterns.

SUMMARY

This application provides a giant cavity surface-emitting laser that can greatly reduce a divergence angle and increase brightness and spectral brightness while maintaining single longitudinal mode lasing and avoiding the problems of complex fabrication, high cost, and low power density.

An embodiment of the present application provides a giant cavity surface-emitting laser. The giant cavity surface-emitting laser includes a giant cavity, a lower Bragg reflector, and an upper Bragg reflector.

The lower Bragg reflector is located on a side of the giant cavity.

The upper Bragg reflector is located on a side of the giant cavity facing away from the lower Bragg reflector.

The giant cavity includes a multi-junction active region containing at least two active layers, and the giant cavity includes at least one of: an anti-reflection light reservoir located between the multi-junction active region and the lower Bragg reflector or an anti-reflection light reservoir located between the multi-junction active region and the upper Bragg reflector, where the anti-reflection light reservoir is configured to increase an optical field intensity peak of the anti-reflection light reservoir to a value higher than an optical field intensity peak of the multi-junction active region and store optical field energy, where a current confinement layer defining a light-emitting region is disposed within the multi-junction active region or near the outer side of the multi-junction active region.

Optionally, the anti-reflection light reservoir includes an anti-reflection layer and a light reservoir.

The anti-reflection layer is located between the light reservoir and the multi-junction active region; the anti-reflection layer is configured to increase the optical field intensity peak of the light reservoir to the value higher than the optical field intensity peak of the multi-junction active region; and the light reservoir is configured to store the optical field energy.

Optionally, along the direction perpendicular to the at least two active layers, the optical thickness of the light reservoir is greater than one-half of the lasing wavelength and is an integer multiple of one-half of the lasing wavelength.

Refractive indices of the light reservoir are uniformly distributed.

Optionally, along the direction from the at least two active layers to the light reservoir, the anti-reflection layer includes a first anti-reflection interface and/or a second anti-reflection interface, the first anti-reflection interface is located between the light reservoir and the at least two active layers and is an interface going from a low refractive index to a high refractive index, and the second anti-reflection interface is located between the light reservoir and the at least two active layers and is an interface going from a high refractive index to a low refractive index.

The optical path length between the first anti-reflection interface and the nearest wave antinode of a standing-wave optical field is less than one-tenth of the lasing wavelength; and the optical path length between the second anti-reflection interface and the nearest wave node of the standing-wave optical field is less than one-tenth of the lasing wavelength.

Optionally, along the direction from the active region to the light reservoir, the optical distance between the first anti-reflection interface of the anti-reflection layer and any interface, which goes from a low refractive index to a high refractive index in one Bragg reflector of the upper Bragg reflector and the lower Bragg reflector, is an integer multiple of half a wavelength, and the one Bragg reflector is located on a side of the at least two active layers facing away from the light reservoir; the optical distance between the first anti-reflection interface of the anti-reflection layer and any interface, which goes from a low refractive index to a high refractive index in the other Bragg reflector of the upper Bragg reflector and the lower Bragg reflector, is an odd multiple of one-quarter of the lasing wavelength, and the other Bragg reflector is located on the same side of the at least two active layers as the light reservoir.

The optical distance between the second anti-reflection interface of the anti-reflection layer and any interface, which goes from a high refractive index to a low refractive index in one Bragg reflector of the upper Bragg reflector and the lower Bragg reflector, is an integer multiple of half a wavelength, and the one Bragg reflector is located on a side of the at least two active layers facing away from the light reservoir; the optical distance between the second anti-reflection interface of the anti-reflection layer and any interface, which goes from a high refractive index to a low refractive index in the other Bragg reflector of the upper Bragg reflector and the lower Bragg reflector, is an odd multiple of one-quarter of the lasing wavelength, and the other Bragg reflector is located on the same side of the at least two active layers as the light reservoir.

Optionally, the anti-reflection light reservoir includes multiple first semiconductor material layers and multiple second semiconductor material layers.

The multiple first semiconductor material layers and the multiple second semiconductor material layers are arranged alternately in sequence.

The number of the multiple first semiconductor material layers is the same as the number of the multiple second semiconductor material layers, the optical thickness of each of the multiple first semiconductor material layers is the same as the optical thickness of each of the multiple second semiconductor material layers, and the refractive index of each of the multiple first semiconductor material layers is different from the refractive index of each of the multiple second semiconductor material layers.

Optionally, at least one current confinement layer is provided, the optical path length between the center of the at least one current confinement layer along the direction perpendicular to the at least two active layers and the nearest wave node of a standing-wave optical field is less than one-tenth of a lasing wavelength, and in the case where the at least one current confinement layer is on the outer side of the multi-junction active region, the at least one current confinement layer is located within two wavelengths from a side of the multi-junction active region along the direction perpendicular to the multi-junction active region.

Optionally, the at least one current confinement layer includes an oxide layer, and the oxide layer is made of epitaxially grown aluminum gallium arsenide (AlGaAs) with high aluminum (Al) content. An oxidized region on the outer side of the oxide layer forms an insulated aluminum oxide film, and an unoxidized region of the oxide layer forms the light-emitting region for effective current injection.

Optionally, the giant cavity surface-emitting laser further includes a substrate, where the substrate is located on a side of the lower Bragg reflector facing away from the at least two active layers, and the material of the substrate includes gallium arsenide (GaAs) or silicon (Si).

Alternatively, a transparent top substrate is further included, where the transparent top substrate is located on a side of the upper Bragg reflector facing away from the at least two active layers, and the material of the transparent top substrate includes sapphire, quartz, glass, or a transparent polymer.

Optionally, along the direction perpendicular to the at least two active layers, the cavity length of the giant cavity

ranges from 1 $\mu$m to 15 $\mu$m.

BRIEF DESCRIPTION OF DRAWINGS

FIG. 1 is a structural diagram of a VCSEL with a small divergence angle;

FIG. 2 is a structural diagram of a giant cavity surface-emitting laser according to an embodiment of the present application;

FIG. 3 is a structural diagram of another giant cavity surface-emitting laser according to an embodiment of the present application;

FIG. 4 is a structural diagram of another giant cavity surface-emitting laser according to an embodiment of the present application;

FIG. 5 is a brightness comparison diagram of a giant cavity surface-emitting laser and a VCSEL according to an embodiment of the present application;

FIG. 6 is a spectral brightness comparison diagram of a giant cavity surface-emitting laser and a VCSEL according to an embodiment of the present application;

FIG. 7 is a structural diagram of another giant cavity surface-emitting laser according to an embodiment of the present application;

FIG. 8 is a structural diagram of another giant cavity surface-emitting laser according to an embodiment of the present application;

FIG. 9 is a structural diagram of another giant cavity surface-emitting laser according to an embodiment of the present application;

FIG. 10 is a diagram illustrating the distribution of optical field intensities and the distribution of refractive indices according to an embodiment of the present application;

FIG. 11 is an enlarged diagram of a partial region in FIG. 10; and

FIG. 12 is another diagram illustrating the distribution of optical field intensities and the distribution of refractive indices according to an embodiment of the present application.

DETAILED DESCRIPTION

The present application is described below in conjunction with drawings and embodiments. The embodiments described herein are merely intended to explain and not to limit the present application. In addition, for ease of description, only part, not all, of the structures related to the present application are illustrated in the drawings.

Due to compactness, fast response capabilities, and high energy conversion efficiency, a VCSEL is the primary light source for high-speed data communications and sensing. Especially in recent years, the VCSEL has been promoted in applications such as facial recognition, infrared lighting, time of flight (ToF), and three-dimensional (3D) sensing in smartphones, tablets, robots, and the like, thereby achieving the unprecedented production of one billion VCSEL chips and VCSEL modules. As the mass production supply chain matures, the large-scale applications of VCSELs expand to autonomous driving, computing, virtualization and augmented reality, industrial rapid heating, aesthetic medicine, and other fields. A solid-state LiDAR system equipped with VCSEL array light sources is developed and commercialized in autonomous vehicles.

High-resolution LiDAR light sources have many performance indicators, such as power, power density, divergence angle, beam quality, beam parameter product, spectral width, brightness, spectral brightness, wavelength, temperature stability, pulse width, energy conversion efficiency, switching speed, module dimensions, and the like. The brightness is particularly important for the LiDAR system that uses collimated laser beams for scanning. The higher the brightness is, the farther away the scanning LiDAR system can sense, and the higher the angular resolution is. At a receiving end, a narrow bandpass filter is usually applied in front of a detector to obtain a high signal-to-noise ratio, thereby achieving a wider detection range. The system signal-to-noise ratio is inversely proportional to the filter bandwidth. The less the filter bandwidth is, the higher the system signal-to-noise ratio is. The bandwidth of a filter covers the entire laser source wavelength shift range under -40°C to 125°C required by the Automotive Electronics Council standards. However, if the wavelength shift temperature coefficient of the filter can be closely matched to the laser source, the bandwidth of the filter can be narrowed significantly. Further, if the wavelength angular shift of the filter can be minimized to negligible, the bandwidth of the filter can even approach the laser spectral width. In this case, the spectral brightness becomes even more important in assessing the ultimate ability of the laser source to achieve a high signal-to-noise ratio. The brightness and the spectral brightness are determined based on formulas (1) and (2), respectively.

$$Brightness = \frac{Power\ density}{\Delta\Omega} = \frac{Power}{A\Delta\Omega} \quad (1)$$

$$Spectral\ Brightness = \frac{Brightness}{\Delta\lambda} = \frac{Power}{A\Delta\Omega\Delta\lambda} \quad (2)$$

The brightness defined in equation (1) is the power density per unit solid angle $\Delta\Omega$ (the unit is steradian (steradian, sr)), and the first five indicators are combined. In equation (1), *Brightness* denotes the brightness, *Power density* denotes the power density, $\Delta\Omega$ denotes the solid angle, $A$ denotes the luminous area, and *Power* denotes the power. The spectral brightness is defined as equation (2), and the first six indicators are combined. In equation (2), *Spectral Brightness* denotes the spectral brightness, and $\Delta\lambda$ denotes the spectral width.

For an array laser source, the luminous area $A$ is defined as the area of the smallest circle or rectangle surrounding all emitters. The solid angle may be expressed as $\Delta\Omega = \iint sin\theta d\theta d\varphi \approx \pi\theta^2$, where $\theta$ denotes a divergence half-angle. In the case where $\theta$ is rather small, $sin\theta \approx \theta$ approximately. $\theta$ and $\varphi$ are two coordinates in the spherical coordinate system, $\theta$ denotes a polar angle, and $\varphi$ denotes an azimuth angle. The denominator $A\Delta\Omega$ (the etendue) in equation (1) is conserved as the beam passes through any ideal collimating lens system. The etendue increases only if none of the optical components in the propagation process are ideal. Similarly, power can only be maintained or reduced due to any optical loss in the propagation process. As a result, the brightness and the spectral brightness can remain constant only in a lossless ideal lens system; otherwise the brightness and the spectral brightness decrease. Therefore, in addition to perfecting the optical components and increasing the laser emission power, reducing the etendue of the original laser beam from the bare chip is essential for achieving high brightness and high spectral brightness of a distant object. Since the power density of the VCSEL is sufficient to satisfy the requirement of the LiDAR, there is an urgent need to reduce the beam divergence angle of the VCSEL to obtain higher brightness and brightness density. The divergence angle of the VCSEL is generally 20° to 30°, which is quite large for most medium- and long-range scanning LiDAR. Due to stronger lateral optical confinement, a multi-junction VCSEL with multiple oxide layers for current confinement has a larger divergence angle than a single-junction VCSEL, but reducing the number of the oxide layers in the multi-junction VCSEL results in the loss of PCE.

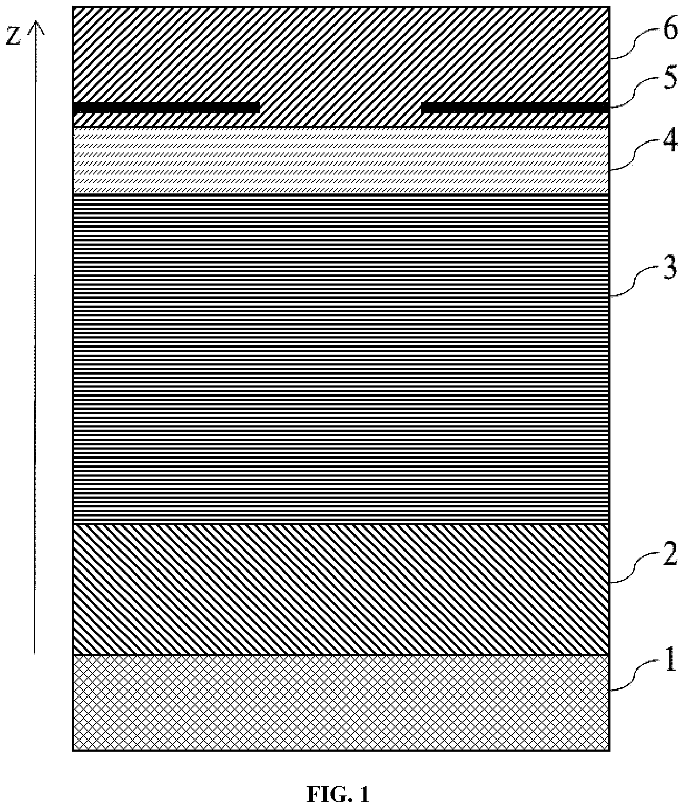

A method for reducing the beam divergence angle of the VCSEL while maintaining efficiency is to use the extended cavity to extend the cavity length. The cavity length is extended so that the effective refractive index difference between the inside and outside of the light-emitting hole of the VCSEL is reduced, thereby suppressing higher-order modes. Since a beam in the higher-order mode has a larger divergence angle, after the beam in the higher-order mode is suppressed, the remaining beam in the lower-order mode can achieve a smaller divergence angle. FIG. 1 is a structural diagram of a VCSEL with a small divergence angle. Referring to FIG. 1, a lower Bragg reflector 2, an active layer 4, and an upper Bragg reflector 6 are disposed on the same side of a substrate 1, where the upper Bragg reflector 6 or the active layer 4 includes a current confinement layer of aluminum gallium arsenide (AlGaAs) with high aluminum (Al) content (the Al content is generally more than 97% or even 100%, that is, pure aluminum arsenide (AlAs)) by oxidation. Aluminum oxide is generated in this layer in a high-temperature water vapor environment and is etched into a columnar platform structure. The columnar platform structure is oxidized from the side surface to form insulating aluminum oxide, and the unoxidized part is still conductive AlGaAs. Such a structure can constrain current to pass only through the middle conductive part. The current confinement layer formed in this manner is generally also called the oxide layer. The opening position is called an oxide hole, which is also the light-emitting hole of the laser. The refractive index of AlGaAs in the middle of the oxide hole is different from the refractive index of aluminum oxide on the outside, resulting in the effective refractive index difference between the inside and outside of the light-emitting hole of the VCSEL.

The effective refractive index is determined based on the formula below.

$$n_{eff} = \frac{\int n(z)E^2(z)dz}{\int E^2(z)dz} \quad (3)$$

$n_{eff}$ denotes the effective refractive index, n(z) denotes the refractive index in the z-axis direction, and $E^2(Z)$ denotes the optical field intensity in the z-axis direction (that is, the light emission direction). The integration range is the range in which the optical field exists in the laser.

The effective refractive index difference between the inside and outside of the light-emitting hole of the VCSEL is determined based on the formula below.

$$\Delta n_{eff} = n_{1_{eff}} - n_{2_{eff}} = \Gamma_{ox} \times (n_1 - n_2) \quad (4)$$

$\Delta n_{eff}$ denotes the effective refractive index difference between the inside and outside of the light-emitting hole, $n_{1\_eff}$ denotes the effective refractive index of the region where the light-emitting hole is located, $n_{2\_eff}$ denotes the effective refractive index outside the light-emitting hole, $n_1$ denotes the refractive index of the material with high aluminum content (such as $Al_{0.98}Ga_{0.02}As$), $n_2$ denotes the refractive index of aluminum oxide, and $\Gamma_{ox}$ denotes the optical confinement factor of the oxide layer and is determined based on the formula below.

$$\Gamma_{ox} = \frac{\int_0^l n_2(z)E^2(z)dz}{\int_0^p n(z)E^2(z)dz} \quad (5)$$

$l$ denotes the thickness of the current confinement layer in the z-axis direction, $p$ denotes the thickness of the entire optical field in the z-axis direction, and $n_2(z)$ denotes the refractive index of aluminum oxide on the z-axis.

To reduce the beam divergence angle of the VCSEL, the cavity length is increased by providing a middle Bragg reflector 3 so that the value of $p$ becomes larger, the value of $\Gamma_{ox}$ becomes smaller, and the effective refractive index difference between the inside and outside of the light-emitting hole is reduced, thereby suppressing higher-order modes. Since a beam in the higher-order mode has a larger divergence angle, after the beam in the higher-order mode is suppressed, the remaining beam in the lower-order mode can achieve a smaller divergence angle. However, the method for increasing the cavity length brings new problems. After the cavity length is increased, the distance between laser longitudinal modes decreases, and multiple longitudinal modes appear in the emission spectrum of the VCSEL, that is, multiple spectral peaks appear. Among the multiple spectral peaks, in addition to the designed lasing wavelength, other undesired spectral peaks appear on one or two sides of the designed lasing wavelength and are commonly referred to as longitudinal modes. The appearance of the side modes causes some potential problems. For example, the receiving end of the LiDAR cannot recognize these side modes, resulting in lower efficiency and crosstalk.

Other methods for reducing the divergence angle include using HCGs, using slow-light optical amplifiers, integration of microlenses, or using different types of current confinement, such as ion implantation and buried tunnel junctions. However, these methods all have challenges, such as complex fabrication, high cost, low power density, and difficulty in achieving uniform light-emitting patterns.

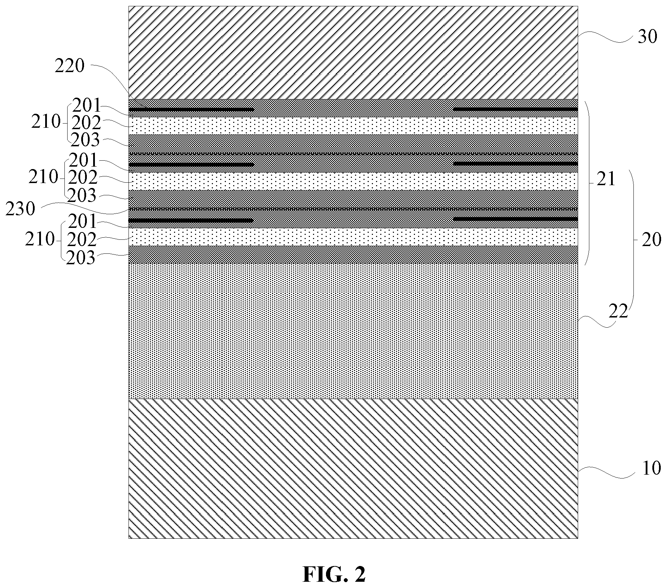

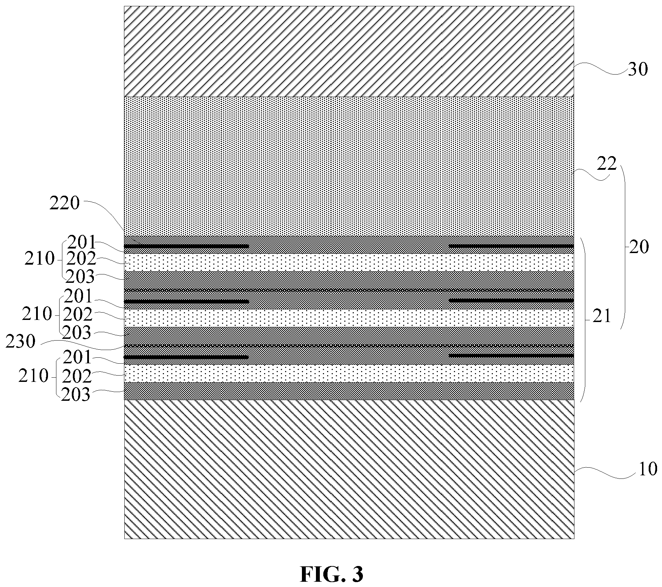

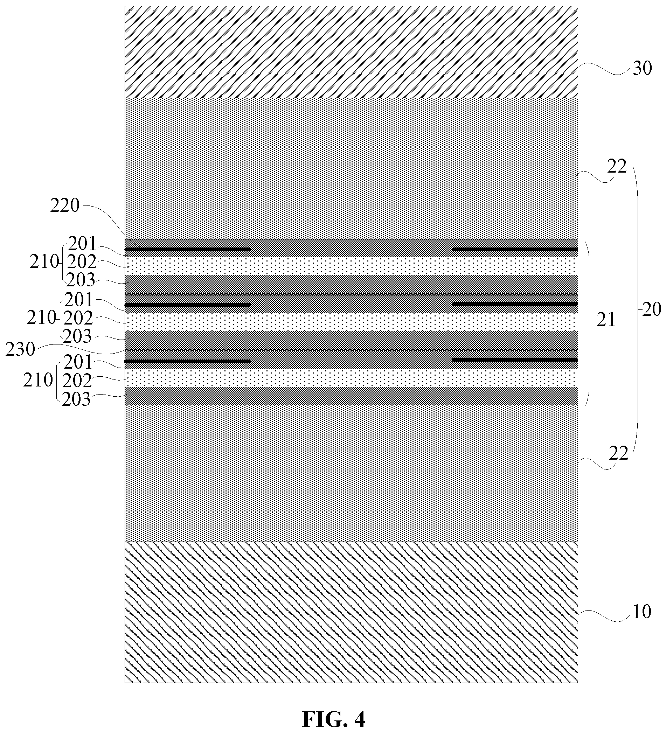

In view of this, the embodiment of the present application provides a giant cavity surface-emitting laser. FIG. 2 is a structural diagram of a giant cavity surface-emitting laser according to an embodiment of the present application. FIG. 3 is a structural diagram of another giant cavity surface-emitting laser according to an embodiment of the present application. FIG. 4 is a structural diagram of another giant cavity surface-emitting laser according to an embodiment of the present application. Referring to FIGS. 2 to 4, the giant cavity surface-emitting laser includes a giant cavity 20, a lower Bragg reflector 10, and an upper Bragg reflector 30.

The lower Bragg reflector 10 is located on a side of the giant cavity 20.

The upper Bragg reflector 30 is located on a side of the giant cavity 20 facing away from the lower Bragg reflector 10.

The giant cavity 20 includes a multi-junction active region 21 containing at least two active layers 210, and the giant cavity 20 includes at least one of: an anti-reflection light reservoir 22 located between the multi-junction active region 21 and the lower Bragg reflector 10 or an anti-reflection light reservoir 22 located between the multi-junction active region 21 and the upper Bragg reflector 30, where the anti-reflection light reservoir 22 is configured to increase an optical field intensity peak of the anti-reflection light reservoir 22 to a value higher than an optical field intensity peak of the multi-junction active region 21 and store optical field energy, and a current confinement layer 220 defining a light-emitting region is disposed within the multi-junction active region 21 or near the outer side of the multi-junction active region 21.

In the technical solution provided in the embodiment of the present application, at least one of the anti-reflection light reservoir 22 between the multi-junction active region 21 and the lower Bragg reflector 10 or the anti-reflection light reservoir 22 between the multi-junction active region 21 and the upper Bragg reflector 30 is provided; the at least one anti-reflection light reservoir 22 can increase the optical field intensity peak of the at least one anti-reflection light reservoir 22 to a value higher than the optical field intensity peak of the multi-junction active region 21 and store optical field energy so that the optical field intensity of the anti-reflection light reservoir 22 is higher than the optical field intensity of the multi-junction active region 21, thereby reducing the effective refractive index difference between the inside and outside of the light-emitting hole of the VCSEL, suppressing higher-order modes, and reducing the divergence angle; at the same time, the optical field intensity inside the anti-reflection light reservoir 22 is increased. Compared with the manner of increasing the cavity length, the magnitude of the cavity length increase can be reduced in this embodiment, thereby improving the problem of multiple longitudinal modes appearing in the emission spectrum of the VCSEL and maintaining single longitudinal mode lasing while greatly reducing the divergence angle. In addition, there is no need to use HCGs, slow-light optical amplifiers, integration of microlens, or different types of current confinement, thereby avoiding problems such as complex fabrication, high cost, and low power density.

For example, the lower Bragg reflector 10 and the upper Bragg reflector 30 are located on opposite sides of the giant cavity 20. The lower Bragg reflector 10 includes multiple reflectors, each reflector has an optical thickness of one-quarter of the lasing wavelength, and the multiple reflectors are disposed alternately at high and low refractive indices; and the upper Bragg reflector 30 includes multiple reflectors, each reflector has an optical thickness of one-quarter of the lasing wavelength, and the multiple reflectors are disposed alternately at high and low refractive indices. The material of the upper Bragg reflector 30 and the material of the lower Bragg reflector 10 may be dielectric materials having electrical insulation properties, for example, silicon nitride, silicon oxide, aluminum oxide, or titanium oxide. The material of the upper Bragg reflector 30 and the material of the lower Bragg reflector 10 may be semiconductor materials, for example, GaAs or AlGaAs.

The current confinement layer 220 is included at an edge facing a side of the multi-junction active region 21 or is disposed within the multi-junction active region 21. The sidewall of a semiconductor layer (for example, the material of the semiconductor layer is AlGaAs) where the current confinement layer 220 is located may be oxidized to form the oxide layer in the manner of highly-aluminum-doped wet oxidation under certain temperature conditions so that the current confinement layer 220 is formed. The current confinement layer 220 has an opening, where the opening is an unoxidized semiconductor layer and is configured to define the light-emitting region of the laser. The aluminum oxide formed after oxidation has relatively high impedance, and the material of the opening position of the current confinement layer 220 is still highly-aluminum-doped AlGaAs. After the current enters, the current flows to the multi-junction active region 21 through the opening in the current confinement layer 220. The multi-junction active region 21 includes at least two active layers 210 for converting electrical energy into optical power to generate laser light. Two adjacent active layers 210 are connected by a tunnel junction 230.

At least one of the anti-reflection light reservoir 22 between the lower Bragg reflector 10 and the multi-junction active region 21 or the anti-reflection light reservoir 22 between the upper Bragg reflector 30 and the multi-junction active region 21 is provided, and the at least one anti-reflection light reservoir 22 is parallel to the active layers 210. In the example of FIG. 2, the anti-reflection light reservoir 22 is disposed between the lower Bragg reflector 10 and the multi-junction active region 21. In the example of FIG. 3, the anti-reflection light reservoir 22 is disposed between the upper Bragg reflector 30 and the multi-junction active region 21. In the example of FIG. 4, the anti-reflection light reservoir 22 between the lower Bragg reflector 10 and the multi-junction active region 21 and the anti-reflection light reservoir 22 between the upper Bragg reflector 30 and the multi-junction active region 21 are both provided. The anti-reflection light reservoir 22 is configured to increase the optical field intensity peak of the anti-reflection light reservoir 22 to a value higher than the optical field intensity peak of the multi-junction active region 21 and store optical field energy, where the material of the anti-reflection light reservoir 22 may be a semiconductor material.

It can be seen from the preceding formulas (3) to (5) that reducing the value of the coefficient $\Gamma\_ox$ can reduce the effective refractive index difference between the inside and outside of the light-emitting hole of the VCSEL. Reducing the value of the coefficient $\Gamma\_ox$ can be achieved by at least one of reducing the numerators of the preceding formulas (3) to (5) or increasing the numerators of the preceding formulas (3) to (5). The thickness of the current confinement layer 220 is relatively small, and increasing the cavity length p in the denominator causes longitudinal modes; therefore, in the embodiment of the present application, the electric field intensity $E^2$ in the denominator, that is, the optical field intensity in the anti-reflection light reservoir 22, is increased so that the effective refractive index difference between the inside and outside of the light-emitting hole of the VCSEL is reduced, thereby suppressing higher-order modes and reducing the divergence angle. At the same time, the optical field intensity inside the anti-reflection light reservoir 22 is increased so that the magnitude of the cavity length increase can be reduced compared to the related art; therefore, the problem of multiple longitudinal modes appearing in the emission spectrum of the VCSEL can be improved so that while the divergence angle is greatly reduced, single longitudinal mode lasing can be maintained, and the problems such as efficiency decline and crosstalk caused by the inability of the receiving end of the LiDAR to recognize these multiple wavelengths can be avoided.

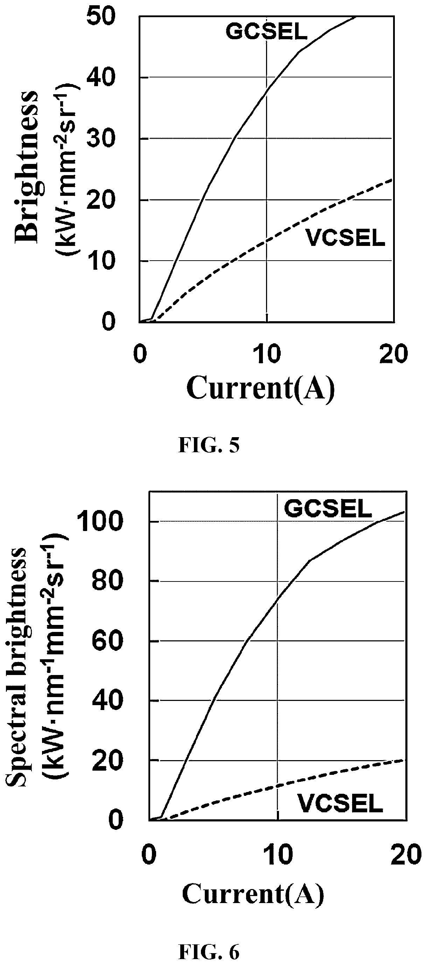

FIG. 5 is a brightness comparison diagram of a giant cavity surface-emitting laser and a VCSEL according to an embodiment of the present application. FIG. 6 is a spectral brightness comparison diagram of a giant cavity surface-emitting laser and a VCSEL according to an embodiment of the present application. Referring to FIGS. 5 and 6, compared with the most advanced multi-junction vertical-cavity surface-emitting laser (VCSEL) used for the LiDAR, the divergence angle of the giant cavity surface-emitting laser (GCSEL) is about half of that of the VCSEL, the brightness of the GCSEL is three times that of the VCSEL, and the spectral brightness of the GCSEL is more than six times that of the VCSEL. This improvement is achieved by relying solely on designing vertically oriented epitaxial structures without any lenses, lateral gratings, or photonic crystals, thereby enabling immediate mass production using the existing low-cost VCSEL manufacturing platform. Further, due to the circular beam shape of the VCSEL and the matching filters to achieve matching of small wavelength shift temperature coefficients, the GCSEL shows great advantages over other types of semiconductor laser sources in the high-brightness LiDAR.

To sum up, the embodiment of the present application proposes a new VCSEL structure that can not only reduce the divergence angle, but also reduce the spectral width, increase the brightness and the spectral brightness, and avoid longitudinal side modes. This new VCSEL structure is called a giant cavity surface-emitting laser. This structure has a giant cavity including a multi-junction active region 21 and at least one anti-reflection light reservoir 22. The electric field intensity in the anti-reflection light reservoir 22 is very high and is much higher than the electric field intensity in the multi-junction active region 21. The total electric field energy stored in such a giant cavity is several times that in an ordinary VCSEL extended cavity with the same volume. The giant cavity significantly reduces the divergence angle of the VCSEL and increases the brightness and the spectral brightness of the VCSEL while maintaining the single longitudinal mode laser. By designing only an epitaxial layer, this giant cavity structure requires neither complex device structure changes nor additional manufacturing steps. Using a standard low-cost VCSEL process, the GCSEL can achieve extremely small full divergence angle, high brightness, and high spectral brightness.

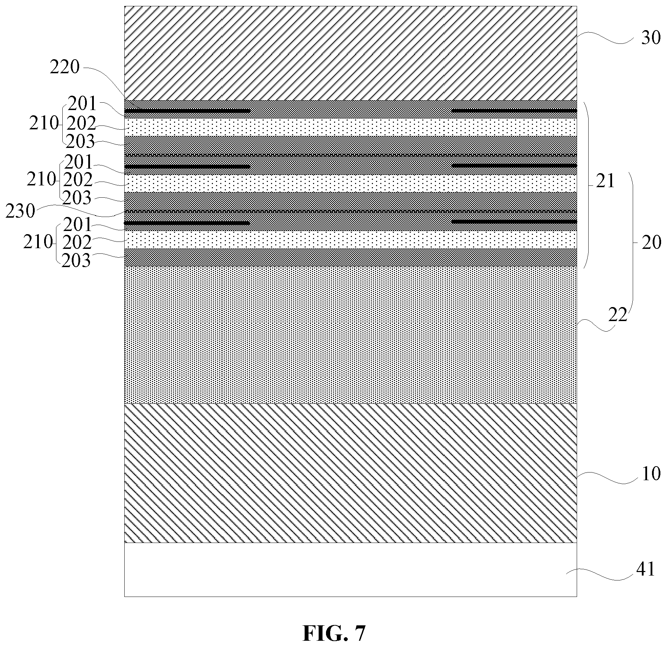

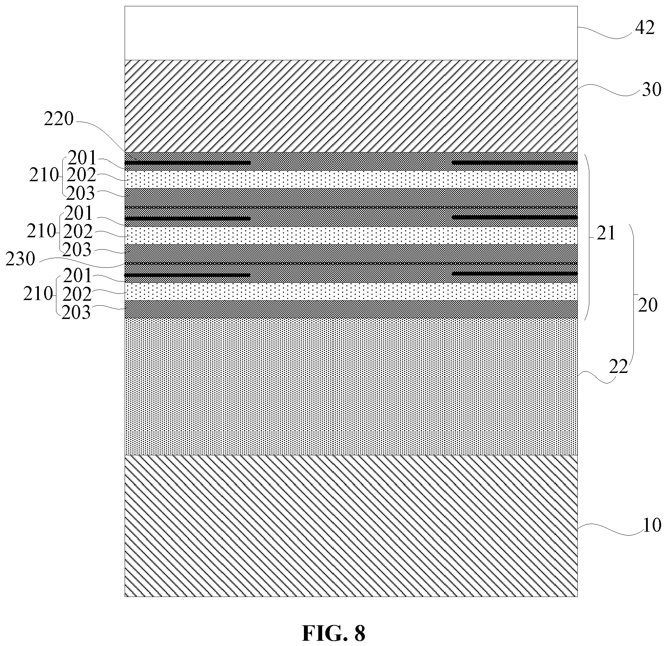

Optionally, FIG. 7 is a structural diagram of another giant cavity surface-emitting laser according to an embodiment of the present application. Referring to FIG. 7, the giant cavity surface-emitting laser may further include a substrate 41. The substrate 41 is located on a side of the lower Bragg reflector 10 facing away from the multi-junction active region 21, the substrate 41 may be any material suitable for forming a laser, and the material of the substrate 41 may be gallium arsenide (GaAs), silicon (Si), or the like. FIG. 8 is a structural diagram of another giant cavity surface-emitting laser according to an embodiment of the present application. Referring to FIG. 8, the giant cavity surface-emitting laser may also be a transparent top substrate 42. While the transparent top substrate 42 is formed, the substrate 41 is removed. The transparent top substrate 42 is located on a side of the upper Bragg reflector 30 facing away from the multi-junction active region 21, and the material of the transparent top substrate 42 may include sapphire, quartz, glass, or a transparent polymer.

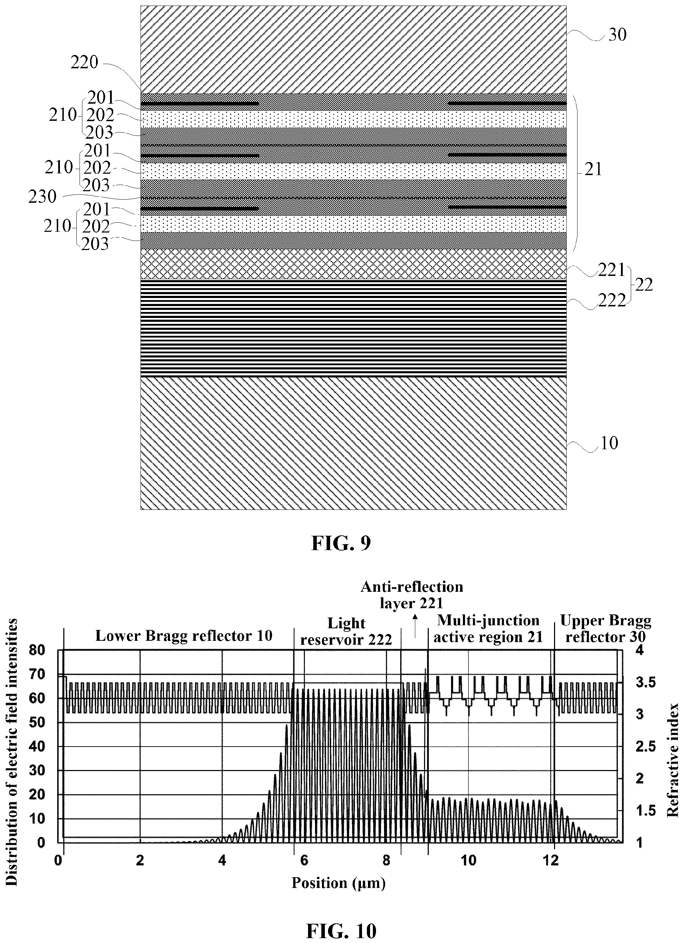

In an embodiment of the present application, referring to FIG. 9, the anti-reflection light reservoir 22 includes an anti-reflection layer 221 and a light reservoir 222.

The anti-reflection layer 221 is located between the light reservoir 222 and the multi-junction active region 21; the anti-reflection layer 221 is configured to increase the optical field intensity peak of the light reservoir 222 to a value higher than the optical field intensity peak of the multi-junction active region 21; and the light reservoir 222 is configured to store the optical field energy.

It is to be understood that in the stacking of lower Bragg reflector 10, the multi-junction active region 21, and the upper Bragg reflector 30, at least one of a light reservoir 222 between the lower Bragg reflector 10 and multi-junction active region 21 or a light reservoir 222 between the upper Bragg reflector 30 and the multi-junction active region 21 is provided, and an anti-reflection layer 221 is disposed between the at least one light reservoir 222 and the multi-junction active layers 210. The light generated in a gain region is enhanced by the anti-reflection layer 221 and the light reservoir 222, where the photons stored in the light reservoir 222 are basically laterally "free", significantly reducing the divergence angle and the spectral width of the laser.

The anti-reflection layer 221 is disposed between the light reservoir 222 and the active layers 210 so that the optical field intensity of the light reservoir 222 is higher than the optical field intensity of the multi-junction active region 21, thereby reducing the effective refractive index difference between the inside and outside of the light-emitting hole of the VCSEL, suppressing higher-order modes, and reducing the divergence angle; at the same time, the optical field intensity inside the light reservoir 222 is increased so that the magnitude of the cavity length increase can be reduced compared to the related art, thereby improving the problem of multiple longitudinal modes appearing in the emission spectrum of the VCSEL and maintaining single longitudinal mode lasing while greatly reducing the divergence angle.

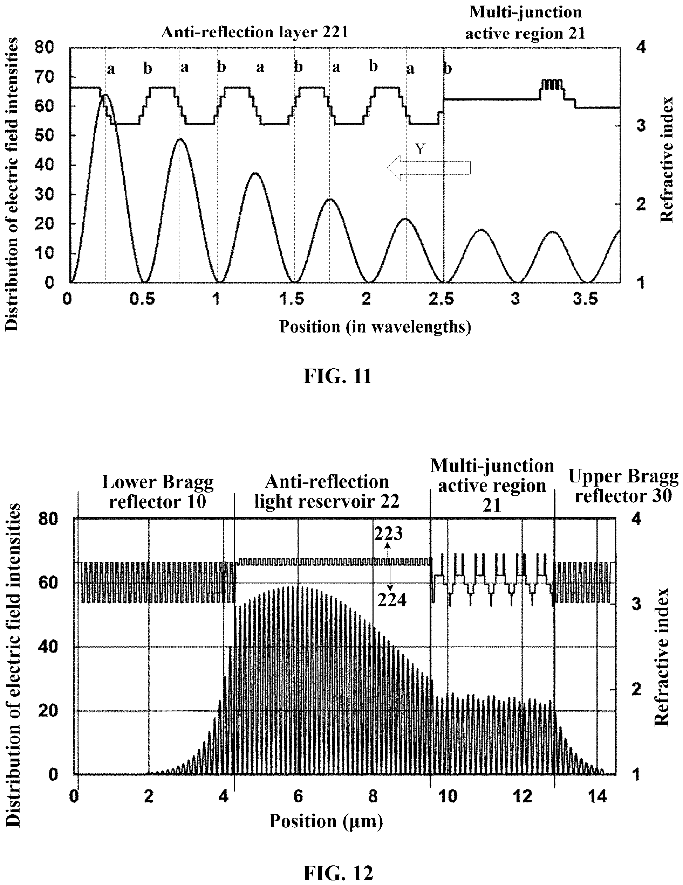

Optionally, FIG. 10 is a diagram illustrating the distribution of optical field intensities and the distribution of refractive indices according to an embodiment of the present application, and FIG. 11 is an enlarged diagram of a partial region in FIG. 10. Referring to FIGS. 9 to 11, along a direction from the active layers 210 to the light reservoir 222, the anti-reflection layer 221 includes a first anti-reflection interface a and/or a second anti-reflection interface b, the first anti-reflection interface a is located between the light reservoir 222 and the multi-junction active region 21 and is an interface going from a low refractive index to a high refractive index, and the second anti-reflection interface b is located between the light reservoir 222 and the multi-junction active region 21 and is an interface going from a high refractive index to a low refractive index.

The optical path length between the first anti-reflection interface a and the nearest wave antinode of a standing-wave optical field is less than one-tenth of the lasing wavelength; and the optical path length between the second anti-reflection interface b and the nearest wave node of the standing-wave optical field is less than one-tenth of the lasing wavelength.

It is to be understood that the direction Y in which the optical field becomes stronger is the direction from the active layers 210 to the light reservoir 222. Along this direction, the interface (the first anti-reflection interface a) from a low refractive index layer to a high refractive index layer in the anti-reflection layer 221 is placed at an optical path length that is less than one-tenth of the lasing wavelength from the nearest wave antinode of the standing-wave optical field; and the interface (the second anti-reflection interface b) from a high refractive index layer to a low refractive index layer in the anti-reflection layer 221 is placed at an optical path length that is less than one-tenth of the lasing wavelength from the nearest wave node of the standing-wave optical electric field. The thicknesses of the high refractive index layer and the low refractive index layer and the positions of the interfaces are adjusted according to the preceding setting rules so that it can be ensured that the direction in which the optical field of the anti-reflection layer 221 becomes stronger is from the multi-junction active region 21 to the light reservoir 222.

For example, referring to FIG. 11, the interface from the low refractive index layer to the high refractive index layer in the anti-reflection layer 221 is placed at the position of the intensity peak of the standing-wave optical field; and the interface from the high refractive index layer to the low refractive index layer in the anti-reflection layer 221 is placed at the wave node of the standing-wave optical field so that the transmittance of the anti-reflection layer 221 can be increased, and the optical field intensity inside the light reservoir 222 can be increased, thereby reducing the effective refractive index difference between the inside and outside of the light-emitting hole of the VCSEL, suppressing higher-order modes, and reducing the divergence angle of the laser.

Optionally, the anti-reflection layer 221 includes at least one anti-reflection interface.

If one anti-reflection interface is provided, the anti-reflection interface is the first anti-reflection interface a or the second anti-reflection interface b, and the anti-reflection interface is a contact interface between the light reservoir 222 and the active layers 210 or an interface where the midpoint of the refractive index of a gradient refractive index layer between the light reservoir 222 and the active layers 210 is located.

For example, for the anti-reflection layer 221 including only one anti-reflection interface, it is to be understood that the contact interface between the light reservoir 222 and the active layers 210 is used as the anti-reflection layer 221, and the thickness of the anti-reflection layer 221 in this case is zero. Here, the gradient refractive index layer may be understood as a film whose refractive index gradually changes from the refractive index at the edge of the active layers 210 to the refractive index at the position of the light reservoir 222 closest to the active layers 210 in the direction from the active layers 210 to the light reservoir 222. The gradient refractive index layer is provided to reduce the resistance caused by the heterojunction. For example, the gradient refractive index layer may be configured to be a gradient layer with a thickness range of 10 to 20 nm and a material of $Al_{0.1}GaAs$ to $Al_{0.8}GaAs$, and correspondingly, the refractive indices are distributed in a gradient manner. It is to be understood that the interface where the midpoint of the refractive index of the gradient refractive index layer is located is used as the anti-reflection layer 221, and the thickness of the anti-reflection layer 221 in this case is zero.

If the anti-reflection layer 221 includes two anti-reflection interfaces, the two anti-reflection interfaces may separately be the first anti-reflection interface a and the second anti-reflection interface b or may each be the first anti-reflection interface a or may each be the second anti-reflection interface b.

For example, in the case where the anti-reflection layer 221 includes two anti-reflection interfaces, one of the anti-reflection interfaces is a contact interface between the light reservoir 222 and the anti-reflection layer 221 or an interface where the midpoint of the refractive index of the gradient refractive index layer between the light reservoir 222 and the anti-reflection layer 221 is located; and the other anti-reflection interface is a contact interface between the active layers 210 and the anti-reflection layer 221 or an interface where the midpoint of the refractive index of the gradient refractive index layer between the active layers 210 and the anti-reflection layer 221 is located. The anti-reflection layer 221 is a single-layer film. In the case where the two anti-reflection interfaces are separately the first anti-reflection interface a and the second anti-reflection interface b, along a direction perpendicular to the active layers 210, the optical thickness between the first anti-reflection interface a and the second anti-reflection interface b is configured to be an odd multiple of one-quarter of the lasing wavelength. In the case where the two anti-reflection interfaces are the first anti-reflection interfaces a or the second anti-reflection interfaces b, along the direction perpendicular to the active layers 210, the optical thickness between the two anti-reflection interfaces is an integer multiple of one-half of the lasing wavelength.

If the anti-reflection layer 221 includes three or more anti-reflection interfaces, m first anti-reflection interfaces and n second anti-reflection interfaces are provided. The distance between any two first anti-reflection interfaces or any two second anti-reflection interfaces is an integer multiple of one-half of the lasing wavelength; and the distance between any first anti-reflection interface and any second anti-reflection interface is an odd multiple of one-quarter of the lasing wavelength.

Referring to FIG. 11, in the case where the anti-reflection layer 221 includes three or more anti-reflection interfaces, the first anti-reflection interfaces a and the second anti-reflection interfaces b may be arranged alternately, and the optical thickness between two adjacent anti-reflection interfaces is one-quarter of the lasing wavelength.

For example, the anti-reflection layer 221 may include multiple sub-layers with different refractive indices, and one anti-reflection interface exists between two adjacent sub-layers. The optical thickness between two adjacent anti-reflection interfaces is an odd multiple of one-quarter of the lasing wavelength. For example, the optical thickness between two adjacent anti-reflection interfaces is set to one-quarter of the lasing wavelength. It is to be understood that the anti-reflection layer 221 is a group of Bragg reflectors with alternately distributed high and low reflectivity sub-layers, each sub-layer having a thickness of 1/4 wavelength. The phase of the group of Bragg reflectors is shifted by 1/4 wavelength, which is equivalent to reflecting light from the light reservoir 222, thereby achieving an anti-reflection effect on the active layers 210. The first anti-reflection interfaces a and the second anti-reflection interfaces b are arranged alternately, and the thickness between two adjacent anti-reflection interfaces is one-quarter of the lasing wavelength. For the anti-reflection layer 221 with the same thickness, the number of anti-reflection interfaces included in the anti-reflection layer 221 can be maximized, the transmittance of the anti-reflection layer 221 can be improved, and the optical field intensity inside the light reservoir 222 can be increased, thereby reducing the effective refractive index difference between the inside and outside of the light-emitting hole of the GCSEL, suppressing higher-order modes, and reducing the divergence angle of the laser.

Optionally, along the direction from the multi-junction active region 21 to the light reservoir 222, the optical distance between the first anti-reflection interface a of the anti-reflection layer 221 and any interface, which goes from a low refractive index to a high refractive index in one Bragg reflector of the upper Bragg reflector 30 and the lower Bragg reflector 10, is an integer multiple of half a wavelength, and the one Bragg reflector is located on a side of the active layers 210 facing away from the light reservoir 222; the optical distance between the first anti-reflection interface a of the anti-reflection layer 221 and any interface, which goes from a low refractive index to a high refractive index in the other Bragg reflector of the upper Bragg reflector 30 and the lower Bragg reflector 10, is an odd multiple of one-quarter of the lasing wavelength, and the other Bragg reflector is located on the same side of the active layers 210 as the light reservoir 222.

The optical distance between the second anti-reflection interface b of the anti-reflection layer 221 and any interface, which goes from a high refractive index to a low refractive index in one Bragg reflector of the upper Bragg reflector 30 and the lower Bragg reflector 10, is an integer multiple of half a wavelength, and the one Bragg reflector is located on a side of the active layers 210 facing away from the light reservoir 222; the optical distance between the second anti-reflection interface b of the anti-reflection layer 221 and any interface, which goes from a high refractive index to a low refractive index in the other Bragg reflector of the upper Bragg reflector 30 and the lower Bragg reflector 10, is an odd multiple of one-quarter of the lasing wavelength, and the other Bragg reflector is located on the same side of the active layers 210 as the light reservoir 222.

Under this setting relationship, the optical thickness of the light reservoir 222 is configured to be an integer multiple of half a wavelength, and the optical thickness of the active layer 210 is configured to be an odd multiple of 1/4 wavelength.

Optionally, referring to FIG. 10, the refractive indices of the light reservoir 222 are uniformly distributed; along the direction perpendicular to the active layers 210, the optical thickness of the light reservoir 222 is greater than one-half of the lasing wavelength and is an integer multiple of one-half of the lasing wavelength.

For example, the refractive indices of the light reservoir 222 are uniformly distributed, and the optical thickness of the light reservoir 222 is an integral multiple of one-half of the lasing wavelength. In this case, the light reservoir 222 may be equivalent to a resonant cavity so that the lower Bragg reflector 10 and the anti-reflection layer 221 that are located on two sides perform reflection in opposite directions, both in the direction towards the light reservoir 222, and the optical field in the resonant cavity is the strongest in the laser, thereby reducing the effective refractive index difference between the inside and outside of the light-emitting hole of the VCSEL, suppressing higher-order modes, and reducing the divergence angle of the laser. In addition, the optical thickness of the light reservoir 222 is configured to be greater than one-half of the lasing wavelength so that the cavity length increased by the light reservoir 222 is larger, and the divergence angle is reduced; and the optical thickness of the light reservoir 222 needs to be less than the corresponding length when the side modes appear.

To sum up, the giant cavity 20 includes one multi-junction active region 21 and at least one anti-reflection light reservoir 22, where the anti-reflection light reservoir 22 has one anti-reflection layer 221 and one light reservoir 222, and the anti-reflection layer 221 is located between the multi-junction active region 21 and the light reservoir 222. The anti-reflection layer 221 is configured to increase the optical field intensity peak of the light reservoir 222 so that the electric field intensity in the light reservoir 222 is much higher than the electric field intensity of the multi-junction active region 21. The total electric field energy stored in such a giant cavity is several times that in an ordinary VCSEL extended cavity with the same volume. The giant cavity significantly reduces the divergence angle of the VCSEL and increases the brightness and the spectral brightness of the VCSEL while maintaining the single longitudinal mode laser. By designing only an epitaxial layer, this structure of the giant cavity 20 requires neither complex device structure changes nor additional manufacturing steps. Using a standard low-cost VCSEL process, the GCSEL can achieve extremely small full divergence angle, high brightness, and high spectral brightness.

In another embodiment of the present application, referring to FIG. 12, the anti-reflection light reservoir 22 includes multiple first semiconductor material layers 223 and multiple second semiconductor material layers 224, where the multiple first semiconductor material layers 223 and the multiple second semiconductor material layers 224 are arranged alternately in sequence; where the number of the multiple first semiconductor material layers 223 is the same as the number of the multiple second semiconductor material layers 224, the optical thickness of the first semiconductor material layer 223 is the same as the optical thickness of the second semiconductor material layer 224, and the refractive index of the first semiconductor material layer 223 is different from the refractive index of the second semiconductor material layer 224. It is to be understood that the anti-reflection layer 221 and the light reservoir 222 are integrated and have the dual functions of the anti-reflection layer 221 and the light reservoir 222 at the same time. The anti-reflection light reservoir 22 includes the multiple first semiconductor material layers 223 and the multiple second semiconductor material layers 224, where the multiple first semiconductor material layers 223 and the multiple second semiconductor material layers 224 are arranged alternately in sequence so that the refractive indices in the anti-reflection light reservoir 22 change periodically, and the optical field intensity peak can be increased to a value higher than the optical field intensity peak of the multi-junction active region 21.

Optionally, referring to FIG. 2, the reflectivity of the upper Bragg reflector 30 is greater than the reflectivity of the lower Bragg reflector 10, and a light-emitting surface or a main light-emitting surface of the laser is located on a side of the lower Bragg reflector 10 facing away from the active layers 210.

Alternatively, the reflectivity of the lower Bragg reflector 10 is greater than the reflectivity of the upper Bragg reflector 30, and the light-emitting surface or the main light-emitting surface of the laser is located on a side of the upper Bragg reflector 30 facing away from the active layers 210.

For example, if the light-emitting surface or the main light-emitting surface of the laser is located on a side of the lower Bragg reflector 10 facing away from the active layers 210, the total reflectivity of reflectors included in the upper Bragg reflector 30 is greater than the total reflectivity of reflectors included in the lower Bragg reflector 10 so that the upper Bragg reflector 30 can achieve total reflection, the lower Bragg reflector 10 can transmit light, and the light emission direction of the laser is a direction from the active layers 210 to the lower Bragg reflector 10, that is, the laser is a back-illuminated laser. If the light-emitting surface or the main light-emitting surface of the laser is located on a side of the upper Bragg reflector 30 facing away from the active layers 210, the total reflectivity of reflectors included in the lower Bragg reflector 10 is greater than the total reflectivity of reflectors included in the upper Bragg reflector 30 so that the lower Bragg reflector 10 can achieve total reflection, the upper Bragg reflector 30 can transmit light, and the light emission direction of the laser is a direction from the active layers 210 to the upper Bragg reflector 30, that is, the laser is a top-illuminated laser. If the refractive index contrast of each reflector pair in the upper Bragg reflector 30 and the lower Bragg reflector 10 is the same, then in the case where the light-emitting surface of the laser is located on a side of the lower Bragg reflector 10 facing away from the active layers 210, the number of reflector pairs included in the upper Bragg reflector 30 is configured to be greater than the number of reflector pairs included in the lower Bragg reflector 10; and in the case where the light-emitting surface of the laser is located on a side of the upper Bragg reflector 30 facing away from the active layers 210, the number of reflector pairs included in the lower Bragg reflector 30 is configured to be greater than the number of reflector pairs included in the upper Bragg reflector 30.

Optionally, referring to FIG. 2, the multi-junction active region 21 includes at least two active layers 210 (three active layers 210 are illustrated in FIG. 2), and two adjacent active sub-layers are connected by the tunnel junction 230. Each active layer 210 may include a quantum well 202 and an N-type semiconductor layer 203 and a P-type semiconductor layer 201 located on two sides of the quantum well 202. At most one current confinement layer 220 exists in each active layer 210, where the optical path length between the tunnel junction 230 and the nearest wave node of the standing-wave optical field is less than one-tenth of the lasing wavelength. For example, the tunnel junction 230 is located at a wave node of the standing-wave optical field. Since the tunnel junction 230 has very high doping, which leads to light absorption losses and reduces luminescence efficiency, placing the tunnel junction 230 where the optical field is smallest can minimize the optical loss. In the structure of multiple active layers 210, only one current confinement layer 220 may be provided, and the current confinement layer 220 is located in the active layer 210 closest to the upper Bragg reflector 30.

Based on any of the preceding embodiments, along the direction perpendicular to the active layers 210, the cavity length of the giant cavity 20 ranges from 1 μm to 15 μm. If the cavity length of the giant cavity 20 is too large, side modes appear. If the cavity length of the giant cavity 20 is too small, to ensure the power density of light, multiple active layers 210 need to be provided in the multi-junction active region 21. Therefore, if the cavity length of the giant cavity 20 is too small, the thickness of the anti-reflection light reservoir 22 is too small, affecting the effect of reducing the divergence angle. Therefore, in the embodiment of the present application, the cavity length of the giant cavity 20 ranges from 1 μm to 15 μm so that while multiple active layers 210 are provided to satisfy the power density requirement of the laser, the thickness requirement of the anti-reflection light reservoir 22 can also be satisfied. For example, the cavity length of the giant cavity 20 ranges from 2 μm to 10 μm.

**Claims**

1. A giant cavity surface-emitting laser, comprising:

   a giant cavity;
   a lower Bragg reflector located on a side of the giant cavity; and
   an upper Bragg reflector located on a side of the giant cavity facing away from the lower Bragg reflector;
   wherein the giant cavity comprises a multi-junction active region containing at least two active layers, and the giant cavity comprises at least one of: an anti-reflection light reservoir located between the multi-junction active region and the lower Bragg reflector or an anti-reflection light reservoir located between the multi-junction active region and the upper Bragg reflector;
   wherein the anti-reflection light reservoir is configured to increase an optical field intensity peak of the anti-reflection light reservoir to a value higher than an optical field intensity peak of the multi-junction active region and store optical field energy;
   wherein a current confinement layer defining a light-emitting region is disposed within the multi-junction active region or near an outer side of the multi-junction active region.

2. The giant cavity surface-emitting laser of claim 1, wherein the anti-reflection light reservoir comprises an anti-reflection layer and a light reservoir;
   wherein the anti-reflection layer is located between the light reservoir and the multi-junction active region; the anti-reflection layer is configured to increase an optical field intensity peak of the light reservoir to the value higher than the optical field intensity peak of the multi-junction active region; and the light reservoir is configured to store the optical field energy.

3. The giant cavity surface-emitting laser of claim 2, wherein along a direction perpendicular to the at least two active layers, an optical thickness of the light reservoir is greater than one-half of a lasing wavelength and is an integer multiple of one-half of the lasing wavelength; and refractive indices of the light reservoir are uniformly distributed.

4. The giant cavity surface-emitting laser of claim 2, wherein along a direction from the multi-junction active region to the light reservoir, the anti-reflection layer comprises at least one of:

   a first anti-reflection interface which is located between the light reservoir and the at least two active layers and is an interface going from a low refractive index to a high refractive index, wherein an optical path length between the first anti-reflection interface and a nearest wave antinode of a standing-wave optical field is less than one-tenth of a lasing wavelength; or
   a second anti-reflection interface which is located between the light reservoir and the at least two active layers and is an interface going from a high refractive index to a low refractive index, wherein an optical path length between the second anti-reflection interface and a nearest wave node of the standing-wave optical field is less than one-tenth of the lasing wavelength.

5. The giant cavity surface-emitting laser of claim 4, wherein along the direction from the multi-junction active region to the light reservoir,

   an optical distance between the first anti-reflection interface of the anti-reflection layer and any interface, which goes from a low refractive index to a high refractive index in one Bragg reflector of the upper Bragg reflector and the lower Bragg reflector, is an integer multiple of half a wavelength, and the one Bragg reflector is located on a side of the at least two active layers facing away from the light reservoir; an optical distance between the first anti-reflection interface and any interface, which goes from a low refractive index to a high refractive index in the other Bragg reflector of the upper Bragg reflector and the lower Bragg reflector, is an odd multiple of one-quarter of the lasing wavelength, and the other Bragg reflector is located on a same side of the at least two active layers as the light reservoir; or
   an optical distance between the second anti-reflection interface of the anti-reflection layer and any interface, which goes from a high refractive index to a low refractive index in one Bragg reflector of the upper Bragg reflector and the lower Bragg reflector, is an integer multiple of half a wavelength, and the one Bragg reflector is located on a side of the at least two active layers facing away from the light reservoir; an optical distance between the second anti-reflection interface and any interface, which goes from a high refractive index to a low refractive index in the other Bragg reflector of the upper Bragg reflector and the lower Bragg reflector, is an odd multiple of one-quarter of the lasing wavelength, and the other Bragg reflector is located on a same side of the at least two active layers as the light reservoir.

6. The giant cavity surface-emitting laser of claim 1, wherein the anti-reflection light reservoir comprises a plurality of first semiconductor material layers and a plurality of second semiconductor material layers, wherein the plurality of first semiconductor material layers and the plurality of second semiconductor material layers are arranged alternately in sequence;
wherein a number of the plurality of first semiconductor material layers is the same as a number of the plurality of second semiconductor material layers, an optical thickness of each of the plurality of first semiconductor material layers is the same as an optical thickness of each of the plurality of second semiconductor material layers, and a refractive index of each of the plurality of first semiconductor material layers is different from a refractive index of each of the plurality of second semiconductor material layers.

7. The giant cavity surface-emitting laser of claim 1, wherein at least one current confinement layer is provided; an optical path length between a center of the at least one current confinement layer along a direction perpendicular to the at least two active layers and a nearest wave node of a standing-wave optical field is less than one-tenth of a lasing wavelength; and in a case where the at least one current confinement layer is on the outer side of the multi-junction active region, the at least one current confinement layer is located within two wavelengths from a side of the multi-junction active region along a direction perpendicular to the multi-junction active region.

8. The giant cavity surface-emitting laser of claim 7, wherein the at least one current confinement layer comprises an oxide layer, and the oxide layer is made of epitaxially grown aluminum gallium arsenide, AlGaAs, with high aluminum, Al, content, wherein an oxidized region on an outer side of the oxide layer forms an insulated aluminum oxide film, and an unoxidized region of the oxide layer forms the light-emitting region for effective current injection.

9. The giant cavity surface-emitting laser of claim 1, further comprising a substrate, wherein the substrate is located on a side of the lower Bragg reflector facing away from the at least two active layers, and material of the substrate comprises gallium arsenide, GaAs, or silicon, Si; or the giant cavity surface-emitting laser further comprising a transparent top substrate, wherein the transparent top substrate is located on a side of the upper Bragg reflector facing away from the at least two active layers, and material of the transparent top substrate comprises sapphire, quartz, glass, or a transparent polymer.

10. The giant cavity surface-emitting laser of any one of claims 1 to 9, wherein along the direction perpendicular to the at least two active layers, a cavity length of the giant cavity ranges from 1 $\mu$m to 15 $\mu$m.

**FIG. 1**

**FIG. 2**

**FIG. 3**

**FIG. 4**

FIG. 5

FIG. 6

**FIG. 7**

**FIG. 8**

**FIG. 9**

**FIG. 10**

**FIG. 11**

**FIG. 12**

| INTERNATIONAL SEARCH REPORT | International application No. |
|---|---|
| | **PCT/CN2023/085835** |

**A. CLASSIFICATION OF SUBJECT MATTER**

H01S5/183(2006.01)i

According to International Patent Classification (IPC) or to both national classification and IPC

**B. FIELDS SEARCHED**

Minimum documentation searched (classification system followed by classification symbols)

IPC: H01S5/-

Documentation searched other than minimum documentation to the extent that such documents are included in the fields searched

Electronic data base consulted during the international search (name of data base and, where practicable, search terms used)

CNTXT, ENTXTC, WPABSC, ENTXT, WPABS, CNKI: 激光 巨腔 面发射 垂直腔 光谱 亮度 发散角 侧模 多结有源区 存储 储存 存光 储光 增透 抗反射 布拉格 光场强度 折射率 laser giant cavity vertical surface emit+ VCSEL GCSEL LIDAR spectral brightness divergence diffusion angle longitudinal side mode? multijunction active reservoir storage memory antireflect + bragg DBR light field intensity refractive index

**C. DOCUMENTS CONSIDERED TO BE RELEVANT**

| Category* | Citation of document, with indication, where appropriate, of the relevant passages | Relevant to claim No. |
|---|---|---|
| PX | CN 115882334 A (VERTILITE CO., LTD.) 31 March 2023 (2023-03-31) description, paragraphs [0006]-[0123], and figures 2-15 | 1-10 |
| PX | CN 115882335 A (VERTILITE CO., LTD.) 31 March 2023 (2023-03-31) description, paragraphs [0006]-[0105], and figures 2-9 | 1-10 |
| A | CN 112470352 A (TRUMPF PHOTONIC COMPONENTS GMBH) 09 March 2021 (2021-03-09) entire document | 1-10 |
| A | CN 107732656 A (HAINAN NORMAL UNIVERSITY) 23 February 2018 (2018-02-23) entire document | 1-10 |
| A | CN 111771312 A (PRINCETON OPTRONICS, INC.) 13 October 2020 (2020-10-13) entire document | 1-10 |
| A | CN 112385099 A (REGENTS OF THE UNIVERSITY OF CALIFORNIA) 19 February 2021 (2021-02-19) entire document | 1-10 |

☑ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 May 2023** | **12 May 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/085835** |

**C.      DOCUMENTS CONSIDERED TO BE RELEVANT**

| Category* | Citation of document, with indication, where appropriate, of the relevant passages | Relevant to claim No. |
| --- | --- | --- |
| A | CN 1588717 A (BEIJING UNIVERSITY OF TECHNOLOGY) 02 March 2005 (2005-03-02) entire document | 1-10 |
| A | CN 1714485 A (JDS UNIPHASE CORP.) 28 December 2005 (2005-12-28) entire document | 1-10 |
| A | US 2016134083 A1 (THE BOARD OF TRUSTEES OF THE UNIVERSITY OF ILLINOIS) 12 May 2016 (2016-05-12) entire document | 1-10 |
| A | US 5295147 A (PHOTONICS RESEARCH, INC.) 15 March 1994 (1994-03-15) entire document | 1-10 |

# EP 4 432 490 A1

## INTERNATIONAL SEARCH REPORT
### Information on patent family members

| International application No. |
| --- |
| **PCT/CN2023/085835** |

| Patent document cited in search report | | | Publication date (day/month/year) | Patent family member(s) | | | Publication date (day/month/year) |
| --- | --- | --- | --- | --- | --- | --- | --- |
| CN | 115882334 | A | 31 March 2023 | WO | 2023050739 | A1 | 06 April 2023 |
| CN | 115882335 | A | 31 March 2023 | WO | 2023050740 | A1 | 06 April 2023 |
| CN | 112470352 | A | 09 March 2021 | EP | 3540879 | A1 | 18 September 2019 |
| | | | | DE | 102019106644 | A1 | 19 September 2019 |
| | | | | US | 2020403376 | A1 | 24 December 2020 |
| | | | | GB | 2573392 | A | 06 November 2019 |
| | | | | WO | 2019175399 | A1 | 19 September 2019 |
| | | | | EP | 3766150 | A1 | 20 January 2021 |
| | | | | FR | 3079080 | A1 | 20 September 2019 |
| CN | 107732656 | A | 23 February 2018 | | None | | |
| CN | 111771312 | A | 13 October 2020 | WO | 2019133655 | A1 | 04 July 2019 |
| | | | | EP | 3732756 | A1 | 04 November 2020 |
| | | | | US | 2021057888 | A1 | 25 February 2021 |
| | | | | TW | 201937820 | A | 16 September 2019 |
| CN | 112385099 | A | 19 February 2021 | WO | 2019217444 | A1 | 14 November 2019 |
| | | | | US | 2021135430 | A1 | 06 May 2021 |
| CN | 1588717 | A | 02 March 2005 | | None | | |
| CN | 1714485 | A | 28 December 2005 | US | 2004096996 | A1 | 20 May 2004 |
| | | | | US | 2004095978 | A1 | 20 May 2004 |
| | | | | US | 6936486 | B2 | 30 August 2005 |
| | | | | US | 2005031005 | A1 | 10 February 2005 |
| | | | | WO | 2004047242 | A1 | 03 June 2004 |
| | | | | AU | 2003291052 | A1 | 15 June 2004 |
| | | | | CN | 100361355 | C | 09 January 2008 |
| US | 2016134083 | A1 | 12 May 2016 | US | 2018041010 | A1 | 08 February 2018 |
| | | | | US | 10381803 | B2 | 13 August 2019 |
| | | | | US | 9742154 | B2 | 22 August 2017 |
| US | 5295147 | A | 15 March 1994 | WO | 9415390 | A1 | 07 July 1994 |

Form PCT/ISA/210 (patent family annex) (July 2022)

25

**REFERENCES CITED IN THE DESCRIPTION**

**Patent documents cited in the description**

- CN 202211393706X
- US 63403301